(19) Europäisches Patentamt
European Patent Office
Office européen des brevets

(11) **EP 3 555 558 B1**

(12) **FASCICULE DE BREVET EUROPEEN**

(45) Date de publication et mention
de la délivrance du brevet:
**05.05.2021 Bulletin 2021/18**

(21) Numéro de dépôt: **17825575.8**

(22) Date de dépôt: **14.12.2017**

(51) Int Cl.:
**G01B 9/02** *(2006.01)*    **G01B 11/22** *(2006.01)*
**H01L 21/66** *(2006.01)*

(86) Numéro de dépôt international:
**PCT/FR2017/053589**

(87) Numéro de publication internationale:
**WO 2018/109410 (21.06.2018 Gazette 2018/25)**

(54) **MÉTHODE ET INSTRUMENT DE MESURE DE PROFONDEUR DE GRAVURE PAR INTERFÉROMÉTRIE POLARIMÉTRIQUE DIFFÉRENTIELLE ET APPAREIL DE SPECTROMÉTRIE DE DÉCHARGE LUMINESCENTE COMPRENANT UN TEL INSTRUMENT DE MESURE**

VERFAHREN UND INSTRUMENT ZUR MESSUNG DER ÄTZTIEFE DURCH DIFFERENZIELLE POLARIMETRISCHE INTERFEROMETRIE UND GLIMMENTLADUNGSSPEKTROMETRIEVORRICHTUNG MIT SOLCH EINEM MESSINSTRUMENT

METHOD AND INSTRUMENT FOR MEASURING ETCH DEPTH BY DIFFERENTIAL POLARIMETRIC INTERFEROMETRY AND GLOW DISCHARGE SPECTROMETRY APPARATUS COMPRISING SUCH A MEASURING INSTRUMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2016 FR 1662644**

(43) Date de publication de la demande:
**23.10.2019 Bulletin 2019/43**

(73) Titulaire: **Horiba France SAS**
**91120 Palaiseau (FR)**

(72) Inventeur: **RICHARD, Simon**
**91120 Palaiseau (FR)**

(74) Mandataire: **Jacobacci Coralis Harle**
**32, rue de l'Arcade**
**75008 Paris (FR)**

(56) Documents cités:
**FR-A1- 3 020 684     US-B1- 6 259 530**

• **PASCAL AMARY ET AL: "<title>New sensor for real-time trench depth monitoring in micromachining applications</title>", PROCEEDINGS OF SPIE, vol. 3874, 30 août 1999 (1999-08-30), pages 205-217, XP055128888, ISSN: 0277-786X, DOI: 10.1117/12.361223**

## Description

DOMAINE TECHNIQUE AUQUEL SE RAPPORTE L'INVENTION

La présente invention concerne de manière générale le domaine des appareils et procédés de mesure *in situ* de profondeur de gravure basé sur des mesures optiques.

Plus précisément, l'invention concerne un appareil et un procédé de mesure *in situ* de profondeur de gravure basé sur une technique d'interférométrie polarimétrique différentielle.

L'invention s'applique en particulier à un système ou un procédé d'analyse de matériaux par spectrométrie de décharge luminescente, cette analyse étant résolue en fonction de la profondeur de gravure dans l'échantillon.

L'invention s'applique notamment à un système ou un procédé d'analyse élémentaire basé sur une décharge luminescente (GD ou Glow Discharge en anglais) couplée à un instrument d'analyse par spectrométrie d'émission optique (GD-OES) ou par spectrométrie de masse (GD-MS). Ainsi, l'invention concerne un appareil et un procédé de spectrométrie de décharge luminescente (GDS pour Glow Discharge Spectrometry) adapté pour mesurer *in situ* la profondeur de gravure d'un échantillon exposé à ce plasma de décharge luminescente.

ARRIERE-PLAN TECHNOLOGIQUE

Dans le présent document, on entend par traitement de gravure, l'exposition d'un matériau ou d'un échantillon solide à un plasma, à un bombardement ionique, à un traitement chimique en phase liquide ou vapeur ou encore à un traitement chimique en phase vapeur assisté par plasma. Selon la composition du matériau à graver différents précurseurs ioniques, liquides et/ou gazeux peuvent être utilisés pour effectuer cette gravure.

Des traitements de gravure de matériaux en couches minces sont couramment utilisés en microélectronique ou dans la fabrication de cellules photovoltaïques pour former des dispositifs électroniques en couches minces.

Il existe des instruments de mesure basés sur la réflectométrie pour contrôler *in situ* la profondeur de gravure en fonction du temps pendant un traitement de gravure. On connait ainsi du document FR2760085 A1 un dispositif de caméra polarimétrique. Toutefois, il est souhaitable d'améliorer la précision et la fiabilité de ces instruments de mesure.

La gravure de matériaux ou de couches minces sert aussi à l'analyse de la composition de ces matériaux. Ainsi, la spectrométrie de décharge luminescente est une technique de mesure qui permet d'analyser la composition chimique élémentaire et/ou moléculaire d'échantillons solides homogènes ou multicouches. La mesure peut se faire au cœur d'un échantillon ou être résolue en profondeur. La spectrométrie de décharge luminescente est couramment utilisée pour analyser la composition d'un échantillon homogène. La spectrométrie de décharge luminescente est également utilisée pour analyser le profil de composition de matériaux solides ou d'échantillons constitués d'empilements de couches minces en fonction de la profondeur de gravure.

Le principe de la spectrométrie de décharge luminescente consiste à exposer une zone limitée d'une face d'un échantillon à un plasma de gravure. Le plasma arrache des atomes à la surface de l'échantillon, et les place dans des états électroniques ionisés ou excités. La nature de ces atomes peut être déterminée par l'analyse du spectre d'émission du plasma ou du spectre de masse des ions produits dans le plasma. Des atomes étant arrachés de la surface exposée au plasma, un cratère se creuse en surface de l'échantillon en fonction du temps d'exposition au plasma. Une analyse des signaux de spectrométrie de masse ou spectrométrie d'émission optique, en fonction du temps d'érosion, permet ainsi d'obtenir la composition de l'échantillon résolue en fonction du temps de gravure.

Cependant, la vitesse de gravure varie généralement au cours du procédé de gravure. La vitesse de gravure varie notamment en fonction de la composition de la zone de l'échantillon exposée au plasma, par exemple en fonction de la composition et/ou structure de différentes couches minces dans un empilement, et aussi en fonction de phénomènes transitoires liés au démarrage du plasma.

Or, il est souhaitable d'analyser la composition en fonction de la profondeur du cratère d'érosion généré par le plasma et pas seulement en fonction du temps pendant le plasma d'érosion.

Il existe différentes méthodes pour mesurer la profondeur du cratère d'érosion en fonction du temps.

La méthode la plus utilisée actuellement est basée sur une calibration de la vitesse d'érosion pour des échantillons de référence de composition connue. Cette calibration nécessite de réaliser différentes mesures sur différents échantillons de référence et repose sur des hypothèses telles que par exemple une densité connue et/ou homogène de la couche ou du matériau considéré. La précision du résultat obtenu reste incertaine.

On connaît notamment du document WO 2015/166186 A1 un système de mesure de la profondeur de gravure combiné à un appareil de spectrométrie de décharge luminescente. Plus précisément, la mesure de profondeur de gravure d'une première zone, exposée au plasma, prend comme référence de profondeur nulle, à chaque instant, une seconde zone de référence sur l'échantillon qui est protégée du plasma. De cette façon, la mesure est insensible aux dilatations de la chambre de gravure.

Néanmoins, on observe des erreurs dans la mesure de profondeur de gravure selon la nature de la couche exposée. Ces erreurs peuvent être relativement importantes pour des valeurs correspondant à une faible profondeur de gravure allant de quelques centaines de nanomètres à quelques micromètres.

OBJET DE L'INVENTION

Afin de remédier à l'inconvénient précité de l'état de la technique, la présente invention propose une méthode de mesure de profondeur de gravure en fonction du temps par interférométrie polarimétrique différentielle comprenant les étapes suivantes :

- séparation d'un faisceau lumineux en un premier faisceau incident et un deuxième faisceau incident, le premier faisceau incident étant dirigé vers une première zone d'un échantillon exposée à un traitement de gravure pour former un premier faisceau réfléchi et, respectivement, le deuxième faisceau incident étant dirigé vers une deuxième zone de l'échantillon pour former un deuxième faisceau réfléchi,
- recombinaison du premier faisceau réfléchi et du deuxième faisceau réfléchi pour former un faisceau interférométrique,
- séparation en polarisation du faisceau interférométrique en au moins une première composante de polarisation et une deuxième composante de polarisation orthogonales entre elles ;
- détection, en fonction du temps (t), sur un intervalle de temps (t0, t1), d'un premier signal d'intensité interférométrique relatif à la première composante de polarisation et d'un deuxième signal d'intensité interférométrique relatif à la deuxième composante de polarisation;
- calcul d'un premier signal d'interférométrie polarimétrique différentiel en fonction de combinaisons linéaires du premier signal d'intensité interférométrique et du deuxième signal d'intensité interférométrique;
- calcul d'une première fonction d'enveloppe inférieure et d'une première fonction d'enveloppe supérieure du premier signal d'interférométrie polarimétrique différentiel sur l'intervalle de temps (t0, t1);
- détermination d'une première fonction de décalage égale à une moitié d'une somme de la première fonction d'enveloppe inférieure et de la première fonction d'enveloppe supérieure à chaque instant (t) de l'intervalle de temps (t0, t1);
- détermination d'une première fonction de normalisation égale à une moitié d'une différence entre la première fonction d'enveloppe inférieure et la première fonction d'enveloppe supérieure chaque instant (t) de l'intervalle de temps (t0, t1) ;
- application de la première fonction de décalage et de la première fonction de normalisation au premier signal d'interférométrie polarimétrique différentiel pour former une première fonction d'interférométrie polarimétrique différentielle normalisée localement à chaque instant (t) de l'intervalle de temps (t0, t1), et
- extraction d'une mesure de déphasage optique en fonction du temps sur ledit intervalle de temps (t0, t1), à partir de la première fonction d'interférométrie polarimétrique différentielle normalisée localement ;
- calcul de la profondeur de gravure en fonction du temps à partir de la mesure de déphasage optique.

Cette méthode permet une normalisation locale (au sens temporel) ou instantanée de la moyenne et de l'amplitude du signal d'interférométrie polarimétrique. La mesure du déphasage extraite est ainsi plus juste, plus précise et moins bruitée.

Cette méthode permet de s'affranchir des variations de coefficient de réflexion de la surface gravée.

De plus, cette normalisation locale à chaque instant t est compatible avec une estimation en temps réel, puisque les fonctions de décalage et d'amplitude peuvent être évaluées à chaque instant de mesure.

De façon avantageuse, la deuxième zone de l'échantillon est une zone de référence qui comporte un masque, par exemple de type masque de photolithographie, ou qui est protégée physiquement vis-à-vis du traitement de gravure. On considère que la gravure de la deuxième zone est négligeable par rapport à la gravure de la première zone.

D'autres caractéristiques non limitatives et avantageuses du procédé conforme à l'invention, prises individuellement ou selon toutes les combinaisons techniquement possibles, sont les suivantes :

- l'étape de séparation en polarisation du faisceau interférométrique génère en outre une troisième composante de polarisation et une quatrième composante de polarisation, lesdites troisième et quatrième composantes de polarisation étant orthogonales entre elles, et les première, deuxième, troisième et quatrième composantes de polarisation étant indépendantes les unes des autres, et la méthode comprenant en outre les étapes suivantes :
- détection, en fonction du temps (t), sur l'intervalle de temps (t0, t1), d'un troisième signal d'intensité interférométrique relatif à la troisième composante de polarisation et d'un quatrième signal d'intensité interférométrique relatif à la quatrième composante de polarisation ;
- calcul d'un deuxième signal d'interférométrie polarimétrique différentiel en fonction de combinaisons linéaires du troisième signal d'intensité interférométrique et du quatrième signal d'intensité interférométrique ;
- calcul d'une deuxième fonction d'enveloppe inférieure et d'une deuxième fonction d'enveloppe supérieure du deuxième signal d'interférométrie polarimétrique différentiel ;
- détermination d'une deuxième fonction de décalage égale à une moitié d'une somme de la deuxième fonction d'enveloppe inférieure et de la deuxième fonction d'enveloppe supérieure à l'instant t ;
- détermination d'une deuxième fonction de normalisation égale à une moitié d'une différence entre la deuxième fonction d'enveloppe inférieure et la deuxième fonction d'enveloppe supérieure à l'instant t;

- application de la deuxième fonction de décalage et de la deuxième fonction de normalisation au deuxième signal d'interférométrie polarimétrique différentiel pour former une deuxième fonction d'interférométrie polarimétrique différentielle normalisée localement, et dans lequel

- l'extraction de la mesure de déphasage optique en fonction du temps sur ledit intervalle de temps (t0, t1) est effectuée à partir d'un rapport entre la première fonction d'interférométrie polarimétrique différentielle normalisée localement et la deuxième fonction d'interférométrie polarimétrique différentielle normalisée localement.

Selon un aspect particulier et avantageux, la troisième composante de polarisation et la quatrième composante de polarisation sont choisies parmi des composantes de polarisation linéaires ou, respectivement, circulaires.

Selon un aspect particulier et avantageux, le deuxième signal d'interférométrie polarimétrique différentiel est égal à une différence entre le troisième signal d'intensité interférométrique et le quatrième signal d'intensité interférométrique divisée par une somme du troisième signal d'intensité interférométrique et du quatrième signal d'intensité interférométrique.

De préférence, la première composante de polarisation et la deuxième composante de polarisation sont choisies parmi des composantes de polarisation linéaires ou, respectivement, circulaires.

Selon un aspect particulier et avantageux, le premier signal d'interférométrie polarimétrique différentiel est égal à une différence entre le premier signal d'intensité interférométrique et le deuxième signal d'intensité interférométrique divisée par une somme du premier signal d'intensité interférométrique et du deuxième signal d'intensité interférométrique.

Dans un mode de réalisation particulier, l'étape de calcul d'une première, et/ou respectivement deuxième, fonction d'enveloppe inférieure comporte une étape d'interpolation linéaire ou polynomiale et/ou dans laquelle l'étape de calcul d'une première, et/ou respectivement deuxième, fonction d'enveloppe supérieure comporte une autre étape d'interpolation linéaire ou polynomiale.

De façon particulièrement avantageuse, la méthode comprend en outre une étape de filtrage du premier signal d'intensité interférométrique et/ou, respectivement, du deuxième signal d'intensité interférométrique, préalable à l'étape de calcul de fonction d'enveloppe.

L'invention propose également un interféromètre polarimétrique différentiel comprenant une source de lumière adaptée pour générer un faisceau lumineux, un séparateur optique de faisceau adapté pour séparer le faisceau lumineux en un premier faisceau incident et un deuxième faisceau incident, le premier faisceau incident étant dirigé vers une première zone d'un échantillon exposée à un traitement de gravure pour former un premier faisceau réfléchi et, respectivement, le deuxième faisceau incident étant dirigé vers une deuxième zone de l'échantillon pour former un deuxième faisceau réfléchi, un combineur de faisceau adapté pour recombiner le premier faisceau réfléchi et le deuxième faisceau réfléchi pour former un faisceau interférométrique, un séparateur de polarisation adapté pour séparer le faisceau interférométrique en au moins une première composante de polarisation et une deuxième composante de polarisation, la première composante de polarisation et la deuxième composante de polarisation étant orthogonales entre elles, un premier détecteur adapté pour recevoir la première composante de polarisation et générer un premier signal d'intensité interférométrique en fonction du temps (t) sur un intervalle de temps (t0, t1) et un deuxième détecteur adapté pour recevoir la deuxième composante de polarisation et générer un deuxième signal d'intensité interférométrique en fonction du temps (t) sur l'intervalle de temps (t0, t1).

Selon l'invention, l'interféromètre polarimétrique différentiel comporte un calculateur adapté pour calculer un premier signal d'interférométrie polarimétrique différentiel en fonction de combinaisons linéaires du premier signal d'intensité interférométrique et du deuxième signal d'intensité interférométrique, calculer une première fonction d'enveloppe inférieure et une première fonction d'enveloppe supérieure du premier signal d'interférométrie polarimétrique différentiel sur l'intervalle de temps (t0, t1), déterminer une première fonction de décalage égale à chaque instant t à une moitié d'une somme de la première fonction d'enveloppe inférieure et de la première fonction d'enveloppe supérieure, déterminer une première fonction de normalisation égale, à chaque instant t de l'intervalle de temps (t0, t1), à une moitié d'une différence entre la première fonction d'enveloppe inférieure et la première fonction d'enveloppe supérieure, appliquer la première fonction de décalage et la première fonction de normalisation au premier signal d'interférométrie polarimétrique différentiel pour former une première fonction d'interférométrie polarimétrique différentielle normalisée localement, et extraire une mesure de déphasage optique en fonction du temps sur ledit intervalle de temps (t0, t1), à partir de la première fonction d'interférométrie polarimétrique différentielle normalisée localement et calculer la profondeur de gravure en fonction du déphasage optique.

Selon un mode de réalisation particulier et avantageux, l'interféromètre polarimétrique différentiel comprend en outre un autre séparateur de polarisation adapté pour séparer le faisceau interférométrique en une troisième composante de polarisation et une quatrième composante de polarisation, la troisième composante de polarisation et la quatrième composante de polarisation étant orthogonales entre elles et étant indépendantes de la première composante de polarisation et de la deuxième composante de polarisation ; un troisième détecteur (83) adapté pour recevoir la troisième composante de polarisation et générer un troisième signal d'intensité interférométrique en fonction du temps (t) sur l'intervalle de temps (t0, t1) et un quatrième détecteur adapté pour recevoir la quatrième composante de polarisation et générer un quatrième signal d'intensité interférométrique en fonction du temps (t) sur l'intervalle de temps (t0, t1); et le calculateur est adapté pour calculer un deuxième signal d'interférométrie polarimétrique différentiel en fonction de combinaisons linéaires du troisième signal d'intensité interférométrique et du quatrième signal d'intensité interférométrique; calculer une deuxième fonction d'enveloppe inférieure et une deuxième fonction d'enveloppe supérieure du deuxième signal d'interférométrie polarimétrique différentiel sur l'intervalle de temps (t0, t1) ; déterminer une deuxième fonction de décalage égale à chaque instant t à une moitié d'une somme de la deuxième fonction d'enveloppe inférieure et de la deuxième fonction d'enveloppe supérieure ; déterminer une deuxième fonction de normalisation égale, à chaque instant t de l'intervalle de temps (t0, t1), à une moitié d'une différence entre la deuxième fonction d'enveloppe inférieure et la deuxième fonction d'enveloppe supérieure ; appliquer la deuxième fonction de décalage et la deuxième fonction de normalisation au deuxième signal d'interférométrie polarimétrique différentiel pour former une deuxième fonction d'interférométrie polarimétrique différentielle normalisée localement, et effectuer l'extraction de la mesure de déphasage optique en fonction du temps sur ledit intervalle de temps (t0, t1) à partir d'un rapport entre la première fonction d'interférométrie polarimétrique différentielle normalisée localement et de la deuxième fonction d'interférométrie polarimétrique différentielle normalisée localement.

L'invention concerne aussi un appareil de spectrométrie de décharge luminescente comprenant un interféromètre polarimétrique différentiel selon l'un des modes de réalisation décrits.

Enfin, l'invention concerne aussi un dispositif de contrôle de gravure comprenant un interféromètre polarimétrique différentiel selon l'un des modes de réalisation décrits combiné à une caméra de visualisation adaptée pour former une image de la première zone et de la deuxième zone de l'échantillon.

DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :

- la figure 1 représente schématiquement un système d'interférométrie polarimétrique différentiel combiné à un appareil de gravure sélective selon un mode de réalisation de l'invention ;

- la figure 2 représente des courbes d'intensité en fonction du temps obtenues à partir de mesures d'interférométrie polarimétrique et un traitement de normalisation globale ;
- la figure 3 représente une mesure de déphasage optique calculée à partir des courbes d'intensité avec normalisation globale de la figure 2 ;
- la figure 4, respectivement la figure 5, représente une acquisition d'intensité interférométrique suivant la polarisation linéaire L, respectivement circulaire C, en fonction du temps ;
- la figure 6 illustre une étape de détermination des minima et maxima locaux sur une courbe d'intensité interférométrique polarisée ;
- la figure 7 illustre une étape de calcul d'une enveloppe de la courbe d'intensité interférométrique polarisée, par interpolation des minima et respectivement des maxima déterminés sur la figure 4 ;
- la figure 8, respectivement la figure 9, représente les mesure d'intensité interférométrique suivant la polarisation linéaire, et respectivement circulaire, après normalisation locale ;
- la figure 10 représente une mesure de déphasage optique calculée à partir des courbes d'intensité avec normalisation locale des figures 8 et 9 ;
- la figure 11 représente une mesure de profondeur de gravure calculée à partir des courbes d'intensité avec normalisation locale des figures 7 et 8 ;
- la figure 12 représente schématiquement un exemple de dispositif de caméra polarimétrique.

La présente divulgation concerne en particulier un procédé et un système de traitement des données d'interférométrie polarimétrique différentielle acquises au cours de la gravure d'un échantillon, dans un réacteur ou dans une source à plasma de décharge luminescente.

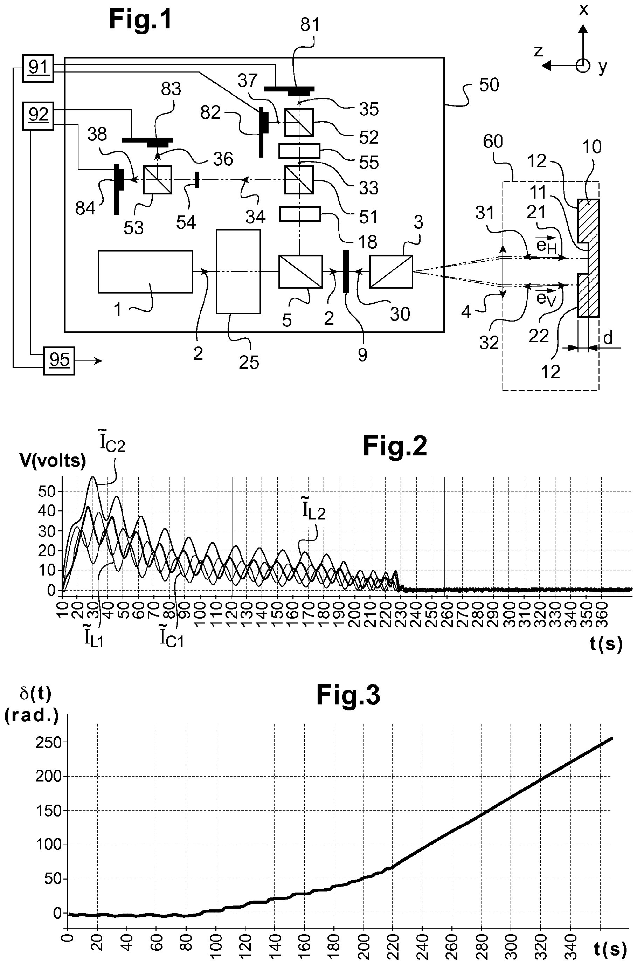

Sur la figure 1 on a représenté schématiquement un appareil 60 de gravure sélective d'un échantillon. Cet appareil peut être un réacteur pour la gravure chimique en phase vapeur ou un réacteur de gravure assisté par plasma. Dans une application particulière, l'appareil 60 est une lampe à décharge pour un spectromètre de décharge luminescente (ou « glow discharge spectrometer » dans la terminologie anglo-saxone).

Un échantillon 10 est disposé dans l'appareil de gravure sélective de manière à ce qu'une première zone 11 soit exposée au traitement de gravure sélective tandis qu'une deuxième zone 12 de l'échantillon est protégée ou masquée vis-à-vis du traitement de gravure. Cette gravure sélective peut résulter d'une configuration du traitement de gravure qui est localisée spatialement sur la première zone 11. De façon alternative, l'appareil comporte un masque ou un écran adapté pour protéger sélectivement la deuxième zone 12 vis-à-vis du traitement de gravure tout en exposant la première zone 11 au traitement de gravure. Selon une autre alternative, la deuxième zone 12 de l'échantillon comporte une couche de masque déposée sur la surface de l'échantillon, cette couche de masque présentant une vitesse de gravure négligeable par rapport à la vitesse de gravure de la première zone 11 lorsque l'échantillon est exposé au traitement de gravure.

Dans l'exemple illustré sur la figure 1, l'échantillon comporte une face plane disposée dans un plan XY d'un repère orthonormé (X, Y, Z). La normale au plan de l'échantillon est parallèle à l'axe Z. On suppose que le traitement de gravure génère un cratère d'érosion à fond plat sur la première zone 11 de l'échantillon 10.

On note d(t) la profondeur de gravure en fonction du temps, c'est-à-dire la distance entre la première zone 11 et la deuxième zone le long de l'axe Z. On cherche à mesurer précisément la profondeur de gravure d(t) en fonction du temps d'exposition au traitement de gravure.

A cet effet, l'appareil 60 de gravure sélective est combiné avec un instrument de mesure *in situ* de profondeur de gravure. On utilise de préférence un système d'interférométrie polarimétrique comprenant un système de détection polarimétrique configuré pour détecter simultanément quatre composantes de polarisation indépendantes du faisceau interférométrique, de préférence deux composantes de polarisation linéaire orthogonales et deux composantes de polarisation circulaire orthogonales.

Le système d'interférométrie polarimétrique comporte essentiellement une source de lumière 1, un séparateur optique de faisceau 3 qui sépare le faisceau source en deux faisceaux incidents se propageant suivant deux chemins optiques séparés, un combineur optique de faisceau qui recombine les deux faisceaux après réflexion sur deux zones distinctes de l'échantillon, un séparateur source-détecteur 5, un système de détection polarimétrique et un système de traitement du signal.

Plus précisément, l'instrument de mesure de profondeur de gravure de la figure 1 comprend une source de lumière 1, qui est par exemple une source laser ou une diode laser. La source de lumière 1 émet un faisceau source 2, de préférence monochromatique, par exemple à une longueur d'onde de 635 nm, ou encore de 780 nm, 532 nm, 405 nm. De façon avantageuse, un isolateur optique 25 est disposé sur le faisceau source 2. Un séparateur source-détecteur 5, par exemple de type lame séparatrice (50-50) ou cube séparateur non-polarisant, est disposé sur le faisceau source 2. Une lame demi-onde 9 permet de d'orienter l'axe de polarisation du faisceau source. Le séparateur source-détecteur 5 dirige le faisceau source 2 vers une lame demi-onde 9 puis vers un autre séparateur de faisceau 3.

Le séparateur de faisceau 3 est par exemple un cube séparateur de polarisation, dont les axes de polarisation sont inclinés à 45 degrés par rapport à l'axe du faisceau incident 2 polarisé linéairement ayant traversé la lame demi-onde 9. A titre d'exemple, le séparateur de faisceau 3 est un prisme de Wollaston qui est adapté pour séparer angulairement le faisceau incident en un premier faisceau incident 21 et un deuxième faisceau incident 22. De façon avantageuse, le premier faisceau incident 21 et le deuxième faisceau incident 22 sont polarisés linéairement suivant des états de polarisations orthogonaux entre eux. Ainsi, le premier faisceau incident 21 polarisé p-est dirigé dans une première direction et le deuxième faisceau incident 22 polarisé s-est dirigé dans une deuxième direction. Par construction du prisme Wollaston 3, la première direction et la deuxième direction sont séparées angulairement d'un angle compris entre 0.1 et 20 degrés.

De façon avantageuse, la lame demi-onde 9 est orientée de manière à ce que le premier faisceau incident 21 et le deuxième faisceau incident 22 aient la même amplitude.

Une lentille 4 est montée sur une ouverture fournissant un accès optique à l'intérieur du réacteur de traitement. De préférence, le séparateur de faisceau 3 est disposé au foyer de la lentille 4. Ainsi, la lentille 4 forme deux faisceaux incidents 21, 22 séparés spatialement qui se propagent parallèlement dans le réacteur de traitement de gravure sélective en direction d'une face de l'échantillon. De cette manière, la lentille 4 focalise le premier faisceau incident 21 sur la première zone 11 de l'échantillon qui est exposée au plasma de gravure. D'autre part, la lentille 4 focalise le deuxième faisceau incident 22 sur la deuxième zone 12 de l'échantillon qui est protégée du plasma de gravure. L'angle d'incidence sur la première zone et sur la seconde zone est généralement inférieur à 10 degrés, et de préférence inférieur ou égal à 5 degrés. Par réflexion sur la première zone 11, le premier faisceau incident 21 forme un premier faisceau réfléchi 31. De manière analogue, par réflexion sur la deuxième zone 12, le deuxième faisceau incident 22 forme un deuxième faisceau réfléchi 32.

Dans une variante, à la place du prisme de Wollaston 3, on peut utiliser un séparateur à décalage de faisceau et remplacer la lentille 4 par une fenêtre.

Selon un mode de réalisation alternatif, on utilise un angle d'incidence non nul par rapport à la normale sur l'échantillon pour séparer angulairement le premier faisceau réfléchi 31 et le deuxième faisceau réfléchi 32 par rapport au premier faisceau incident 21 et au deuxième faisceau incident 22. De cette façon le faisceau réfléchi recombiné 30 est séparé spatialement du faisceau incident 2, sans requérir un séparateur source-détecteur.

Dans l'exemple illustré sur la figure 1, l'échantillon présente une face plane et la gravure de la première zone 11 génère un cratère à fond plat. De préférence, comme illustré dans cet exemple, les faisceaux incidents 21, 22 se réfléchissent sur l'échantillon sous un angle d'incidence nul. Dans ce cas, le premier faisceau réfléchi 31 se propage dans la direction opposée au premier faisceau incident 21, et, respectivement, le deuxième faisceau réfléchi 32 se propage dans la direction opposée au premier faisceau incident 22.

La lentille 4 collecte le premier faisceau réfléchi 31 et le deuxième faisceau réfléchi 32 et les dirige vers un système optique de recombinaison, qui est ici le même prisme de Wollaston 3 ayant servi à séparer le faisceau incident.

Le prisme de Wollaston 3 recombine le premier faisceau réfléchi 31 et le deuxième faisceau réfléchi 32 pour former un faisceau interférométrique 30. Le faisceau interférométrique 30 traverse la lame demi-onde 9 et est incident sur le séparateur source-détecteur 5 non-polarisant qui le réfléchit en direction d'un système de détection polarimétrique.

Le filtre 18 est un filtre spectral, de préférence centré sur la longueur d'onde d'émission de la source lumineuse 1. Le filtre 18 permet avantageusement d'éliminer la lumière parasite provenant du plasma ou de l'éclairage ambiant. Le filtre 18 est par exemple un filtre interférentiel centré à 635 nm d'une largeur spectrale de 10 nm.

Le système de détection polarimétrique comporte un séparateur non polarisant 51, un premier séparateur de polarisation 52 et un deuxième séparateur de polarisation 53, une lame quart d'onde 54, un rotateur de polarisation 55 et quatre détecteurs 81, 82, 83, 84. Dans un mode de réalisation alternatif, les positions des éléments 54 et 55 peuvent être interverties.

Avantageusement, le séparateur non polarisant 51 préserve au mieux l'état de polarisation du faisceau interférométrique incident à la fois sur les voies transmise et réfléchie. A ce titre les séparateurs non polarisant pour laser, optimisés pour une plage de longueur d'onde étroite sont préférables aux séparateurs large bande, couvrant par exemple tout le visible. Le séparateur non polarisant 51 reçoit le faisceau interférométrique 30 et le sépare pour former une première fraction de faisceau interférométrique 33 sur la voie de transmission du séparateur non polarisant 51 et, respectivement, une seconde fraction de faisceau interférométrique 34 sur la voie de réflexion du séparateur non polarisant 51.

Le rotateur de polarisation 55 est associé au séparateur de polarisation 52 pour former un analyseur de polarisations linéaires orientées à 45 degrés des axes du séparateur de faisceau 3. Le détecteur 81 détecte une composante de polarisation linéaire 35 de la première fraction de faisceau interférométrique 33, cette composante de polarisation linéaire 35 étant orientée à +45 degrés des axes du séparateur de faisceau 3. Simultanément, le détecteur 82 détecte une autre composante de polarisation linéaire 37 de la première fraction de faisceau interférométrique 33, cette autre composante de polarisation linéaire 37 étant orientée à -45 degrés des axes du séparateur de faisceau 3.

La lame quart-d'onde 54 est associée au séparateur de polarisation 53 pour former un analyseur de polarisations circulaires, respectivement circulaire droite et circulaire gauche. Le détecteur 83 détecte la composante de polarisation circulaire droite 36 de la seconde fraction de faisceau interférométrique 34. Simultanément, le détecteur 84 détecte la composante de polarisation circulaire gauche 38 de la seconde fraction de faisceau interférométrique 34.

Ainsi, le système de détection polarimétrique de la figure 1 permet de détecter simultanément les quatre composantes de polarisation indépendantes du faisceau interférométrique 30.

A partir des quatre signaux détectés par les quatre détecteurs 81, 82, 83, 84, il est possible d'en déduire le déphasage entre le faisceau réfléchi 31 par la première zone 11, c'est-à-dire dans le cratère résultant de la gravure de l'échantillon, et le faisceau réfléchi 32 par la deuxième zone 12, qui sert de référence.

De façon particulièrement avantageuse, le système de détection polarimétrique est configuré pour détecter simultanément au moins deux et de préférence quatre composantes de polarisation orthogonales du faisceau interférométrique, c'est-à-dire au moins deux composantes orthogonales de polarisation linéaire et/ou deux composantes orthogonales de polarisation circulaire.

Nous détaillons d'abord l'approche classique d'analyse des signaux correspondant aux quatre composantes de polarisation.

On note :

- $I_{L1}$ l'intensité de la composante linéaire du faisceau interférométrique selon une direction à +45 degrés par rapport à la polarisation linéaire horizontale (H) du champ incident sur la première zone et par rapport à la polarisation linéaire verticale (V) du champ incident sur la seconde zone ;
- $I_{L2}$ l'intensité de la composante linéaire du faisceau interférométrique selon une direction de -45 degrés par rapport à la polarisation linéaire H du champ incident sur la première zone et par rapport à la polarisation linéaire V du champ incident sur la seconde zone ;
- $I_{C1}$ l'intensité de la composante circulaire droite du faisceau interférométrique, et
- $I_{C2}$ l'intensité de la composante circulaire gauche du faisceau interférométrique.

Pendant la gravure de l'échantillon, la profondeur de la première zone augmente et donc la différence de phase entre les deux ondes réfléchies varie en fonction du temps t.

Plus précisément, notons δ(t) le déphasage optique relatif entre le premier faisceau réfléchi et le deuxième faisceau réfléchi :

$$\delta(t) = 2kd(t) + \varphi_H + \varphi_V$$

où $k=2\pi/\lambda$, et $d(t)$ représente la profondeur de gravure en fonction du temps.

On exprime par les relations suivantes $r_V$ le coefficient de réflexion sur la première zone et $r_H$ le coefficient de réflexion sur la deuxième zone:

$$r_V = \rho_V \, exp(i\varphi_V)$$

$$r_H = \rho_H \, exp(i\varphi_H)$$

En interférométrie polarimétrique, on calcule classiquement, d'une part, la différence d'intensité normalisée L entre les intensités détectées sur les voies de polarisation linéaires :

$$L = \frac{I_{L1} - I_{L2}}{I_{L1} + I_{L2}} = \frac{2 \, E_V E_H \rho_V \rho_H \cos(\delta(t))}{E_V^2 \, \rho_V^2 + E_H^2 \, \rho_H^2}$$

D'autre part, on calcule classiquement la différence d'intensité normalisée C entre les intensités détectées sur les voies de polarisation circulaires :

$$C = \frac{I_{C1} - I_{C2}}{I_{C1} + I_{C2}} = \frac{2 \, E_V E_H \rho_V \rho_H \sin(\delta(t))}{E_V^2 \, \rho_V^2 + E_H^2 \, \rho_H^2}$$

Théoriquement, on montre que le déphasage $\delta(t)$ relatif entre les deux faisceaux optiques réfléchis s'écrit :

$$\delta(t) = \tan^{-1}\left(\frac{I_{C1} - I_{C2}}{I_{C1} + I_{C2}} \cdot \frac{I_{L1} + I_{L2}}{I_{L1} - I_{L2}}\right)$$

Autrement formulé :

$$\delta(t) = \tan^{-1}\left(\frac{C}{L}\right)$$

On déduit de ce déphasage la différence de profondeur relative d(t) entre les deux zones sur lesquelles sont dirigés les deux faisceaux incidents.

En pratique, la détection polarimétrique peut être affectée par des défauts dus aux composants optiques, miroirs, séparateur et/ou combineur de faisceau. De plus, les signaux polarimétriques peuvent aussi être affectés par des modifications des propriétés de l'échantillon lui-même en fonction du temps de gravure. L'évolution de l'état de surface et/ou de la rugosité peut modifier les signaux polarimétriques.

Il existe une méthode dite de normalisation globale pour corriger certains effets indésirables.

Dans le cas d'une détection polarimétrique idéale, et d'une recombinaison imparfaite des faisceaux et des miroirs, les signaux d'intensité polarimétrique reçus respectivement sur les quatre détecteurs 81, 82, 83, 84 peuvent s'écrire respectivement sous la forme suivante :

$$I_{L_1} = a_{L_1} + b_{L_1} \cdot \cos \delta(t)$$

$$I_{L_2} = a_{L_2} - b_{L_2} \cdot \cos \delta(t)$$

$$I_{C_1} = a_{C_1} + b_{C_1} \cdot \sin \delta(t)$$

$$I_{C_2} = a_{C_2} + b_{C_2} \cdot \sin \delta(t)$$

Où le coefficient a représente un paramètre de décalage et, respectivement, le coefficient b représente un paramètre d'amplitude.

En utilisant une période d'échantillonnage où seulement $\delta(t)$ varie, par exemple sur un substrat de référence, on peut calculer des paramètres du type décalage (offset) a et amplitude b pour chaque intensité polarimétrique tels que:

$$a = \frac{\max(I) + \min(I)}{2}$$

$$b = \frac{\max(I) - \min(I)}{2}$$

On calcule ainsi une intensité normalisée de manière globale $\tilde{I}$:

$$\tilde{I} = \frac{I - a}{b}$$

On en déduit $\delta(t)$ par l'équation suivante :

$$\tan \delta(t) = \frac{\widetilde{I_{C2}} - \widetilde{I_{C1}}}{\widetilde{I_H} - \widetilde{I_V}}$$

Cette normalisation globale est satisfaisante dans certaines situations, mais présente des inconvénients. Tout d'abord, l'utilisateur doit définir une zone temporelle de normalisation après l'acquisition des données. Par conséquent, cette normalisation est incompatible avec une estimation en temps réel. L'expérience montre que pour un échantillon donné, un seul jeu de coefficients de normalisation ne peut pas être utilisé pour plusieurs mesures. De plus, cette normalisation globale suppose l'unicité des coefficients de normalisation pour une mesure donnée, alors que l'expérience montre que certains échantillons ont une rugosité de surface qui évolue pendant la mesure, ce qui affecte les résultats.

La figure 2 illustre un exemple de mesure normalisée suivant la technique de normalisation globale.

L'échantillon est formé d'une couche de nitrure de titane ayant une épaisseur d'environ 4 microns sur un substrat de carbure de tungstène. Les courbes sont enregistrées lors de la gravure de l'échantillon. La normalisation est effectuée sur une partie temporelle de la courbe (dans l'exemple représenté correspondant à t > 220 s). Puis, on extrapole en appliquant les mêmes coefficients sur la reste de la courbe (t<220 s).On a représenté respectivement les courbes normalisées globalement $\widetilde{I_{C1}}$ , $\widetilde{I_{C2}}$ , $\widetilde{I_{L_1}}$ et $\widetilde{I_{L_2}}$ en fonction du temps t sur un intervalle de temps s'étendant de 0 à 360 s. Le traitement de gravure démarre à l'instant t=0. Dans la partie des courbes où t est supérieur à environ 220 s, les courbes oscillent entre les valeurs +1 et -1. On observe donc une normalisation globale correcte sur la partie des courbes d'intensité correspondant à t> 220 s. Par contre, la normalisation globale apparaît clairement inadaptée sur la première partie des courbes, pour t < 220 s.

La figure 3 illustre le déphasage temporel calculé à partir de ces courbes d'intensité normalisées globalement telles que représentées sur la figure 2. Le déphasage temporel δ(t) semble varier de manière monotone avec un bruit réduit dans la partie où t >220 s. Par contre, pour t < 220 s, on observe des sauts de phase et une évolution de la phase différente de l'évolution linéaire attendue. En effet, pendant la première partie jusqu'à t -100 s, le déphasage oscille autour d'une valeur moyenne nulle, ce qui conduit à une erreur d'évaluation importante sur la profondeur de gravure.

Nous allons maintenant détailler une approche innovante d'analyse des signaux d'interférométrie polarimétrique.

Comme détaillé ci-dessus, le système de détection polarimétrique à quatre détecteurs illustré sur la figure 1 permet de détecter simultanément deux signaux interférométriques de polarisation linéaires orthogonales $I_{L1}$ et $I_{L2}$ et/ou deux signaux interférométriques de polarisation circulaires orthogonales $I_{C1}$ et $I_{C2}$ A titre, d'exemple, le signal $I_{L1}$ représente une polarisation horizontale, respectivement le signal $I_{L2}$ représente une polarisation verticale, le signal $I_{C1}$ représente une polarisation circulaire droite et le signal $I_{C2}$ représente une polarisation circulaire gauche.

Sur la figure 1, le système de détection polarimétrique est relié à différents modules de calcul 91, 92, 95 faisant partie d'un processeur de calcul.

Le module de calcul 91 utilise un premier rapport de combinaisons linéaires des intensités de deux signaux interférométriques détectés sur les voies de polarisation linéaires orthogonales, $I_{L1}$ et $I_{L2}$, pour former une première différence d'intensité normalisée L à chaque instant t :

$$L = \frac{I_{L1} - I_{L2}}{I_{L1} + I_{L2}}$$

Ainsi, le module de calcul 91 peut fournir en temps réel, ou en post-traitement, la valeur de L(t) à chaque instant t.

De façon particulièrement avantageuse, le module de calcul 92 utilise un deuxième rapport de combinaisons linéaires des intensités de deux autres signaux interférométriques détectés sur les voies de polarisation circulaires orthogonales, $I_{C1}$ et $I_{C2}$, pour former une deuxième différence d'intensité normalisée C à chaque instant t :

$$C = \frac{I_{C1} - I_{C2}}{I_{C1} + I_{C2}}$$

Ainsi, le module de calcul 92 peut fournir en temps réel, ou en post-traitement la valeur de C(t) à chaque instant t.

La première différence d'intensité normalisée L est une fonction de cos(δ(t)) et, respectivement, la deuxième différence d'intensité normalisée C de est une fonction de sin(δ(t)):

$$L \approx \alpha_L(t) + \beta_L(t) \cos \delta(t)$$

$$C \approx \alpha_C(t) + \beta_C(t) \sin \delta(t)$$

Le but est de calculer cos(δ(t)) et sin(δ(t))à partir de ces mesures.

On considère ici un échantillon non transparent, pour lequel les variations de phase sont proportionnelles aux variations de profondeur de gravure.

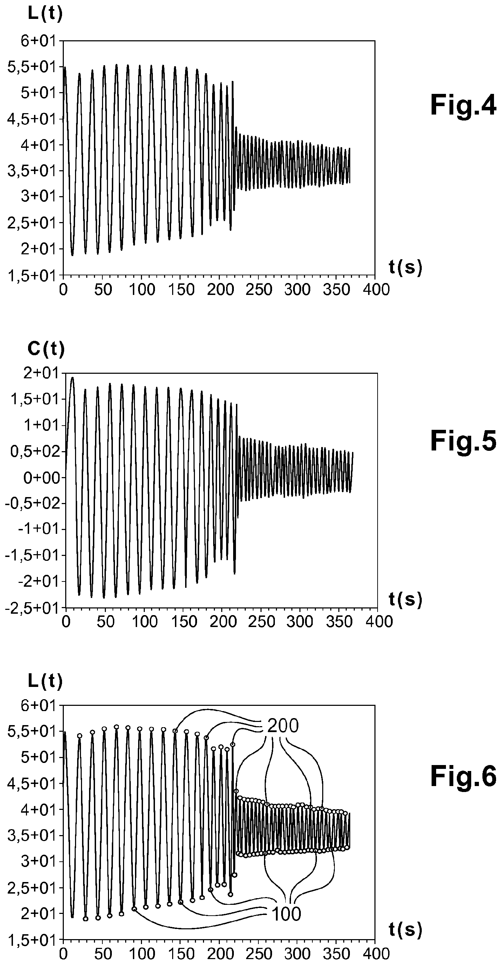

Sur la figure 4, on a représenté un enregistrement de la première différence d'intensité normalisée L en fonction du temps t sur l'intervalle temporel (0 ;360s) pour l'échantillon décrit ci-dessus. De même, sur la figure 5, on a représenté un enregistrement de la différence d'intensité normalisée C en fonction du temps t sur l'intervalle temporel (0 ;360s) pour le même échantillon.

On observe que les variations de l'enveloppe des signaux, définies par les variables $\alpha_{L,C}$ et $\beta_{L,C}$ sont lentes à l'intérieur de chaque couche de matériau, avec des variations parfois abruptes à l'interface entre deux couches. Toutefois, l'enveloppe des signaux a généralement un comportement sans oscillations.

Le traitement des données comporte ensuite les étapes suivantes.

Etape 1 :

Pour chaque courbe de différence d'intensité normalisée en fonction du temps t, on détermine les minima et maxima locaux. Autrement dit, on trouve les hauts et les bas à chaque oscillation.

Ainsi, sur la figure 6, on a représenté des petits cercles 100 correspondant aux minima locaux, et, respectivement, des petits cercles 200 correspondant aux maxima locaux sur la courbe de la première différence d'intensité normalisée L.

Dans une variante de cette étape, on effectue au préalable un filtrage, par exemple par échantillonnage et/ou par calcul d'une moyenne afin de réduire le bruit.

Selon un aspect particulier, le module de calcul 91, respectivement 92, élimine les faux minima et faux maxima. Par exemple, on vérifie qu'un minima ou un maxima de L est positionné au milieu de l'intervalle temporel entre un minimum et un maximum de C et vice versa

Etape 2 :

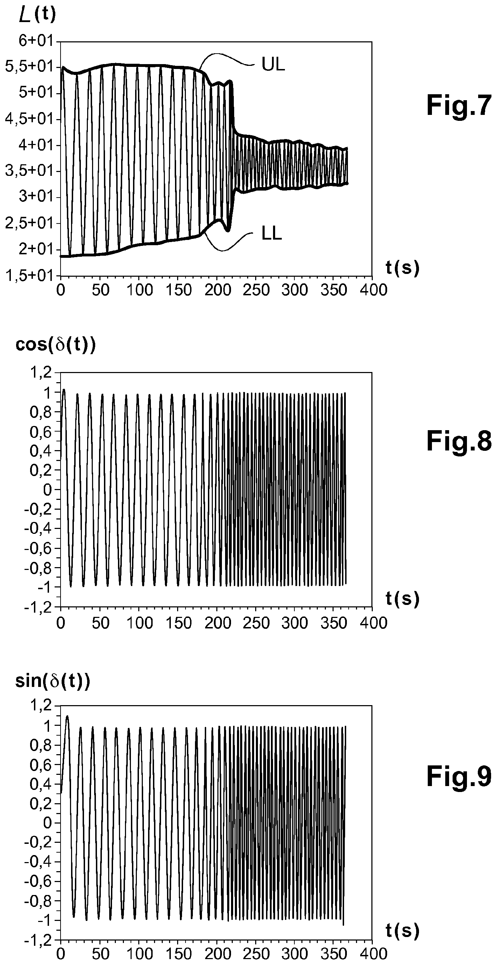

On détermine une courbe d'enveloppe supérieure UL par interpolation entre les maxima locaux 200 de la première différence d'intensité normalisée *L* (voir Fig. 7). De manière analogue, on détermine une courbe d'enveloppe inférieure LL par interpolation entre les minima locaux 100 de la première différence d'intensité normalisée *L*. L'interpolation peut être linéaire ou basée sur une fonction de spline ou une décomposition polynomiale.

Le module de calcul 91 est avantageusement configuré pour calculer les courbes d'enveloppe inférieure UL(t) et d'enveloppe supérieure LL(t) à chaque instant t ou suivant une période d'échantillonnage prédéterminée.

De façon particulièrement avantageuse, on détermine de manière analogue, une autre courbe d'enveloppe supérieure UC par interpolation entre les maxima locaux de la deuxième différence d'intensité normalisée C et, respectivement, une autre courbe d'enveloppe inférieure LC par interpolation entre les minima locaux de la deuxième différence d'intensité normalisée C.

De manière analogue, le module de calcul 92 est configuré pour calculer les courbes d'enveloppe inférieure UC(t) et d'enveloppe supérieure LC(t) à chaque instant t ou suivant la période d'échantillonnage prédéterminée.

Etape 3 :

Un autre module de calcul 95 reçoit les courbes d'enveloppe UL(t), LL(t), UL(t) et LL(t).

Le module de calcul 95 calcule une première fonction de décalage à chaque instant t :

$$\alpha_L(t) = \frac{UL(t) + LL(t)}{2}$$

Le module de calcul 95 calcule une première fonction de normalisation à chaque instant t :

$$\beta_L(t) = \frac{UL(t) - LL(t)}{2}$$

De façon avantageuse, le module de calcul 95 calcule une deuxième fonction de décalage à chaque instant t :

$$\alpha_C(t) = \frac{UC(t) + LC(t)}{2}$$

Le module de calcul 95 calcule une deuxième fonction de normalisation à chaque instant t :

$$\beta_C(t) = \frac{UC(t) - LC(t)}{2}$$

Le module de calcul 95 applique la première fonction de décalage $\alpha_L(t)$ et la première fonction de normalisation $\beta_L(t)$ au premier signal d'interférométrie polarimétrique différentiel, pour calculer une première fonction d'interférométrie polarimétrique différentielle normalisée et en déduire :

$$\cos(\delta(t)) \approx \frac{L(t) - \alpha_L(t)}{\beta_L(t)}$$

La figure 8 représente ainsi la première fonction d'interférométrie polarimétrique différentielle normalisée égale à cos(δ(t)) en fonction du temps t.

De façon analogue, on applique la deuxième fonction de décalage $\alpha_C(t)$ et la *L* fonction de normalisation $\beta_C(t)$ au deuxième signal d'interférométrie polarimétrique, pour calculer une deuxième fonction d'interférométrie polarimétrique différentielle normalisée et en déduire :

$$\sin(\delta(t)) \approx \frac{C(t) - \alpha_C(t)}{\beta_C(t)}$$

La figure 9 représente ainsi la deuxième fonction d'interférométrie polarimétrique différentielle normalisée égale à sin(δ(t))en fonction du temps t.

On observe que la normalisation locale est quasiment parfaite sur tout l'intervalle de temps (0 ; 360s) sur les figures 8 et 9, les courbes oscillant entre les valeurs de -1 et +1 sur tout l'intervalle de temps, malgré le changement d'interface à environ 220s.

Etape 4 :

Le module de calcul 95 extrait le déphasage instantané δ(t), par exemple en calculant la fonction arctangente du rapport entre la deuxième fonction d'interférométrie polarimétrique différentielle normalisée, sin(δ(t)), et la première fonction d'interférométrie polarimétrique différentielle normalisée, cos(δ(t)).

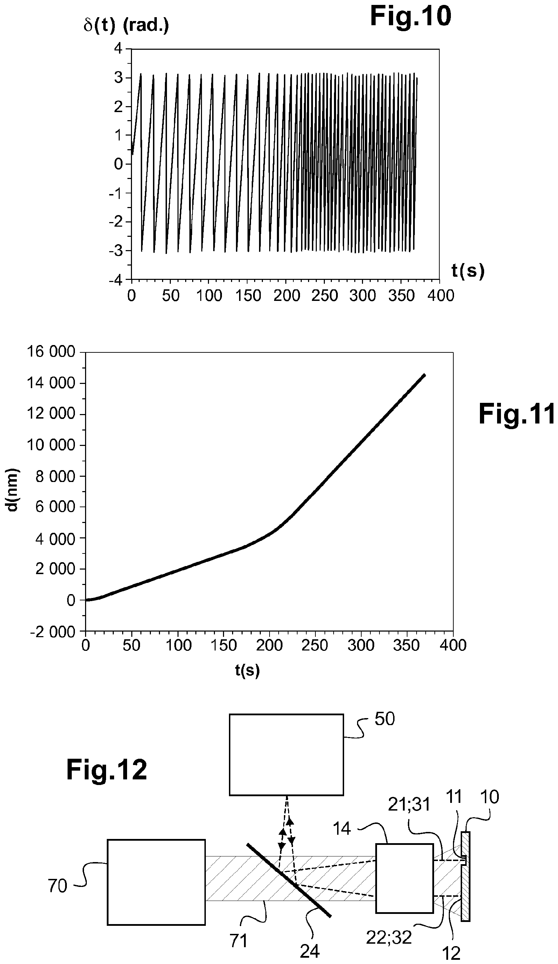

La figure 10 représente ainsi le déphasage en radians, en fonction du temps, modulo $\pi$. Un algorithme permet de déplier le déphasage en fonction du temps. Dans l'air ou le vide, l'indice de réfraction du cratère de gravure est égal à 1. Un facteur de conversion de 50,5 nm/rad. permet d'en déduire la profondeur de gravure d(t) en fonction du temps, comme illustré sur la figure 11.

En comparant l'allure de la figure 3 et celle de la figure 11, on observe que les erreurs dues à la normalisation globale ont disparu.

La méthode permet une normalisation locale automatique des signaux d'interférométrie polarimétrique différentielle. Il n'est pas nécessaire d'effectuer une calibration préalable.

L'utilisateur n'intervient pas manuellement pour définir l'intervalle temporel de normalisation.

De plus, il n'est pas nécessaire d'enregistrer des coefficients de calibration.

Dans un mode de réalisation, les calculs sont effectués a posteriori.

Dans une variante, les calculs sont effectués en temps réel, avec ajustement au fur et à mesure de l'acquisition de nouvelles mesures.

L'invention trouve une application particulière dans un appareil de spectrométrie de décharge luminescente, où l'échantillon est exposé à un traitement de gravure sélective par plasma. L'instrument de mesure de profondeur de gravure permet une mesure plus précise et fiable de la profondeur de gravure dans l'échantillon.

L'invention trouve aussi une application particulière dans un dispositif de caméra polarimétrique, illustré à titre d'exemple en figure 12. Le dispositif de caméra polarimétrique comporte un interféromètre polarimétrique différentiel 50 tel que décrit dans la présente divulgation et un système d'imagerie 70. Le système d'imagerie comporte une caméra de visualisation et, de préférence, une source lumineuse d'éclairage. Le dispositif de caméra polarimétrique comporte en outre une lame séparatrice 24 et un système optique 14 à base de lentille(s) ou de miroir(s). La lame séparatrice 24 est par exemple une lame dichroïque permet de combiner les trajets optiques de l'interféromètre polarimétrique différentiel 50 et du système d'imagerie 70. La lame séparatrice 24 combinée au système optique 14 dirige le premier faisceau incident 21 vers une première zone 11 de l'échantillon, et, respectivement, le deuxième faisceau incident 22 vers une deuxième zone 12 de l'échantillon. Dans le sens retour, le système optique 14 combiné à la lame séparatrice 24 renvoie le premier faisceau réfléchi 31 et le deuxième faisceau réfléchi 32 vers le système de détection de l'interféromètre polarimétrique différentiel 50.

Simultanément, le système optique 14 combiné à la lame séparatrice 24 transmet un faisceau lumineux 71 vers la caméra de visualisation du système d'imagerie 70. Le faisceau lumineux 71 est formé par réflexion sur une surface étendue de l'échantillon comprenant de préférence la première zone 11 et la deuxième zone 12. La caméra de visualisation forme ainsi l'image de la surface de l'échantillon 10.

Le dispositif de caméra polarimétrique permet ainsi de mesurer précisément la profondeur de gravure entre la première zone 11 et la deuxième zone 12 de l'échantillon, tout en fournissant une image d'une surface étendue de l'échantillon.

**Revendications**

1. Méthode de mesure de profondeur de gravure en fonction du temps par interférométrie polarimétrique différentielle comprenant les étapes suivantes :

   - séparation d'un faisceau lumineux (2) en un premier faisceau incident (21) et un deuxième faisceau incident (22), le premier faisceau incident (21) étant dirigé vers une première zone (11) d'un échantillon (10) exposée à un traitement de gravure pour former un premier faisceau réfléchi (31) et, respectivement, le deuxième faisceau incident (22) étant dirigé vers une deuxième zone (12) de l'échantillon pour former un deuxième faisceau réfléchi (32),
   - recombinaison du premier faisceau réfléchi (31) et du deuxième faisceau réfléchi (32) pour former un faisceau interférométrique,
   - séparation en polarisation du faisceau interférométrique en au moins une première composante de polarisation (35) et une deuxième composante de polarisation (37) orthogonales entre elles ;
   - détection, en fonction du temps (t), sur un intervalle de temps (t0, t1), d'un premier signal d'intensité interférométrique relatif à la première composante de polarisation (35) et d'un deuxième signal d'intensité interférométrique relatif à la deuxième composante de polarisation (37) ;
   - calcul d'un premier signal d'interférométrie polarimétrique différentiel en fonction de combinaisons linéaires du premier signal d'intensité interférométrique et du deuxième signal d'intensité interférométrique;
   - calcul d'une première fonction d'enveloppe inférieure et d'une première fonction d'enveloppe supérieure du premier signal d'interférométrie polarimétrique différentiel sur l'intervalle de temps (t0, t1);
   - détermination d'une première fonction de décalage égale à une moitié d'une somme de la première fonction d'enveloppe inférieure et de la première fonction d'enveloppe supérieure à chaque instant (t) de l'intervalle de temps (t0, t1);
   - détermination d'une première fonction de normalisation égale à une moitié d'une différence entre la première fonction d'enveloppe inférieure et la première fonction d'enveloppe supérieure chaque instant (t) de l'intervalle de temps (t0, t1) ;

- application de la première fonction de décalage et de la première fonction de normalisation au premier signal d'interférométrie polarimétrique différentiel pour former une première fonction d'interférométrie polarimétrique différentielle normalisée localement à chaque instant (t) de l'intervalle de temps (t0, t1), et

- extraction d'une mesure de déphasage optique en fonction du temps sur ledit intervalle de temps (t0, t1), à partir de la première fonction d'interférométrie polarimétrique différentielle normalisée localement ;

- calcul de la profondeur de gravure en fonction du temps à partir de la mesure de déphasage optique.

2. Méthode selon la revendication 1 dans laquelle l'étape de séparation en polarisation du faisceau interférométrique génère en outre une troisième composante de polarisation (36) et une quatrième composante de polarisation (38), lesdites troisième et quatrième composantes de polarisation étant orthogonales entre elles, et les première, deuxième, troisième et quatrième composantes de polarisation étant indépendantes les unes des autres, et la méthode comprenant en outre les étapes suivantes :

- détection, en fonction du temps (t), sur l'intervalle de temps (t0, t1), d'un troisième signal d'intensité interférométrique relatif à la troisième composante de polarisation et d'un quatrième signal d'intensité interférométrique relatif à la quatrième composante de polarisation ;

- calcul d'un deuxième signal d'interférométrie polarimétrique différentiel en fonction de combinaisons linéaires du troisième signal d'intensité interférométrique et du quatrième signal d'intensité interférométrique ;

- calcul d'une deuxième fonction d'enveloppe inférieure et d'une deuxième fonction d'enveloppe supérieure du deuxième signal d'interférométrie polarimétrique différentiel ;

- détermination d'une deuxième fonction de décalage égale à une moitié d'une somme de la deuxième fonction d'enveloppe inférieure et de la deuxième fonction d'enveloppe supérieure à l'instant t ;

- détermination d'une deuxième fonction de normalisation égale à une moitié d'une différence entre la deuxième fonction d'enveloppe inférieure et la deuxième fonction d'enveloppe supérieure à l'instant t;

- application de la deuxième fonction de décalage et de la deuxième fonction de normalisation au deuxième signal d'interférométrie polarimétrique différentiel pour former une deuxième fonction d'interférométrie polarimétrique différentielle normalisée localement, et dans lequel

- l'extraction de la mesure de déphasage optique en fonction du temps sur ledit intervalle de temps (t0, t1) est effectuée à partir d'un rapport entre la première fonction d'interférométrie polarimétrique différentielle normalisée localement et la deuxième fonction d'interférométrie polarimétrique différentielle normalisée localement.

3. Méthode selon la revendication 2 dans laquelle la troisième composante de polarisation et la quatrième composante de polarisation sont choisies parmi des composantes de polarisation linéaires ou, respectivement, circulaires.

4. Méthode selon l'une des revendications 2 à 3 dans laquelle le deuxième signal d'interférométrie polarimétrique différentiel est égal à une différence entre le troisième signal d'intensité interférométrique et le quatrième signal d'intensité interférométrique divisée par une somme du troisième signal d'intensité interférométrique et du quatrième signal d'intensité interférométrique.

5. Méthode selon l'une des revendications 1 à 4 dans laquelle la première composante de polarisation et la deuxième composante de polarisation sont choisies parmi des composantes de polarisation linéaires ou, respectivement, circulaires.

6. Méthode selon l'une des revendications 1 à 5 dans laquelle le premier signal d'interférométrie polarimétrique différentiel est égal à une différence entre le premier signal d'intensité interférométrique et le deuxième signal d'intensité interférométrique divisée par une somme du premier signal d'intensité interférométrique et du deuxième signal d'intensité interférométrique.

7. Méthode selon l'une des revendications 1 à 6 dans laquelle l'étape de calcul d'une première, et/ou respectivement deuxième, fonction d'enveloppe inférieure comporte une étape d'interpolation linéaire ou polynomiale et/ou dans laquelle l'étape de calcul d'une première, et/ou respectivement deuxième, fonction d'enveloppe supérieure comporte une autre étape d'interpolation linéaire ou polynomiale.

8. Méthode selon l'une des revendications 1 à 7 comprenant en outre une étape de filtrage du premier signal d'intensité interférométrique et/ou, respectivement, du deuxième signal d'intensité interférométrique, préalable à l'étape de calcul de fonction d'enveloppe.

**9.** Interféromètre polarimétrique différentiel comprenant :

- une source de lumière (1) adaptée pour générer un faisceau lumineux (2) ;
- un séparateur optique de faisceau (3) adapté pour séparer le faisceau lumineux (2) en un premier faisceau incident (21) et un deuxième faisceau incident (22), le premier faisceau incident (21) étant dirigé vers une première zone (11) d'un échantillon exposée à un traitement de gravure pour former un premier faisceau réfléchi (31) et, respectivement, le deuxième faisceau incident (22) étant dirigé vers une deuxième zone (12) de l'échantillon pour former un deuxième faisceau réfléchi (32),
- un combineur de faisceau (3) adapté pour recombiner le premier faisceau réfléchi (31) et le deuxième faisceau réfléchi (32) pour former un faisceau interférométrique,
- un séparateur de polarisation (52) adapté pour séparer le faisceau interférométrique en au moins une première composante de polarisation (35) et une deuxième composante de polarisation (37), la première composante de polarisation et la deuxième composante de polarisation étant orthogonales entre elles ;
- un premier détecteur (81) adapté pour recevoir la première composante de polarisation (35) et générer un premier signal d'intensité interférométrique en fonction du temps (t) sur un intervalle de temps (t0, t1) et un deuxième détecteur (82) adapté pour recevoir la deuxième composante de polarisation (37) et générer un deuxième signal d'intensité interférométrique en fonction du temps (t) sur l'intervalle de temps (t0, t1);

**caractérisé en ce que** l'interféromètre polarimétrique différentiel comporte un calculateur (91, 92, 95) adapté pour :

- calculer un premier signal d'interférométrie polarimétrique différentiel en fonction de combinaisons linéaires du premier signal d'intensité interférométrique et du deuxième signal d'intensité interférométrique;
- calculer une première fonction d'enveloppe inférieure et une première fonction d'enveloppe supérieure du premier signal d'interférométrie polarimétrique différentiel sur l'intervalle de temps (t0, t1) ;
- déterminer une première fonction de décalage égale à chaque instant t à une moitié d'une somme de la première fonction d'enveloppe inférieure et de la première fonction d'enveloppe supérieure ;
- déterminer une première fonction de normalisation égale, à chaque instant t de l'intervalle de temps (t0, t1), à une moitié d'une différence entre la première fonction d'enveloppe inférieure et la première fonction d'enveloppe supérieure ;
- appliquer la première fonction de décalage et la première fonction de normalisation au premier signal d'interférométrie polarimétrique différentiel pour former une première fonction d'interférométrie polarimétrique différentielle normalisée localement, et
- extraire une mesure de déphasage optique en fonction du temps sur ledit intervalle de temps (t0, t1), à partir de la première fonction d'interférométrie polarimétrique différentielle normalisée localement ;
- calculer la profondeur de gravure en fonction du déphasage optique.

**10.** Interféromètre polarimétrique différentiel selon la revendication 9 comprenant en outre :

- un autre séparateur de polarisation (53) adapté pour séparer le faisceau interférométrique en une troisième composante de polarisation (36) et une quatrième composante de polarisation (38), la troisième composante de polarisation (36) et la quatrième composante de polarisation (38) étant orthogonales entre elles et étant indépendantes de la première composante de polarisation (35) et de la deuxième composante de polarisation (37) ;
- un troisième détecteur (83) adapté pour recevoir la troisième composante de polarisation (36) et générer un troisième signal d'intensité interférométrique en fonction du temps (t) sur l'intervalle de temps (t0, t1) et un quatrième détecteur (84) adapté pour recevoir la quatrième composante de polarisation (38) et générer un quatrième signal d'intensité interférométrique en fonction du temps (t) sur l'intervalle de temps (t0, t1);

et dans lequel le calculateur est adapté pour :

- calculer un deuxième signal d'interférométrie polarimétrique différentiel en fonction de combinaisons linéaires du troisième signal d'intensité interférométrique et du quatrième signal d'intensité interférométrique;
- calculer une deuxième fonction d'enveloppe inférieure et une deuxième fonction d'enveloppe supérieure du deuxième signal d'interférométrie polarimétrique différentiel sur l'intervalle de temps (t0, t1) ;
- déterminer une deuxième fonction de décalage égale à chaque instant t à une moitié d'une somme de la deuxième fonction d'enveloppe inférieure et de la deuxième fonction d'enveloppe supérieure ;

- déterminer une deuxième fonction de normalisation égale, à chaque instant t de l'intervalle de temps (t0, t1), à une moitié d'une différence entre la deuxième fonction d'enveloppe inférieure et la deuxième fonction d'enveloppe supérieure ;

- appliquer la deuxième fonction de décalage et la deuxième fonction de normalisation au deuxième signal d'interférométrie polarimétrique différentiel pour former une deuxième fonction d'interférométrie polarimétrique différentielle normalisée localement, et

- effectuer l'extraction de la mesure de déphasage optique en fonction du temps sur ledit intervalle de temps (t0, t1) à partir d'un rapport entre la première fonction d'interférométrie polarimétrique différentielle normalisée localement et de la deuxième fonction d'interférométrie polarimétrique différentielle normalisée localement.

**11.** Appareil de spectrométrie de décharge luminescente comprenant un interféromètre polarimétrique différentiel selon l'une des revendications 9 à 10.

**12.** Dispositif de contrôle de gravure comprenant un interféromètre polarimétrique différentiel selon l'une des revendications 9 à 10 combiné à une caméra de visualisation adaptée pour former une image de la première zone et de la deuxième zone de l'échantillon.

**Patentansprüche**

**1.** Verfahren zur Messung der Ätztiefe in Abhängigkeit von der Zeit durch differentielle polarimetrische Interferometrie, das die folgenden Schritte aufweist:

- Aufteilung eines Lichtstrahls (2) in einen ersten einfallenden Strahl (21) und einen zweiten einfallenden Strahl (22), wobei der erste einfallende Strahl (21) auf eine erste Zone (11) einer einem Ätzverfahren unterzogenen Probe (10) gerichtet wird, um einen ersten reflektierten Strahl (31) zu erzeugen, und entsprechend der zweite einfallende Strahl (22) auf eine zweite Zone (12) der Probe gerichtet wird, um einen zweiten reflektierten Strahl (32) zu erzeugen,

- Rekombination des ersten reflektierten Strahls (31) und des zweiten reflektierten Strahls (32), um einen interferometrischen Strahl zu bilden,

- Aufteilung des interferometrischen Strahls durch Polarisation in wenigstens eine erste Polarisationskomponente (35) und eine zweite Polarisationskomponente (37), die zueinander senkrecht stehen,

- Erfassen, in Abhängigkeit von der Zeit (t), über einen Zeitabschnitt (t0, t1), eines ersten Signals interferometrischer Stärke bezüglich der ersten Polarisationskomponente (35) und eines zweiten Signals interferometrischer Stärke bezüglich der zweiten Polarisationskomponente (37),

- Berechnung eines ersten differentiellen Signals polarimetrischer Interferometrie in Abhängigkeit von linearen Kombinationen des ersten Signals interferometrischer Stärke und des zweiten Signals interferometrischer Stärke,

- Berechnung einer ersten unteren Hüllfunktion und einer ersten oberen Hüllfunktion des ersten differentiellen Signals polarimetrischer Interferometrie im Zeitabschnitt (t0, t1),

- Bestimmung einer ersten Verlageiangsfunktion, die gleich einer Hälfte einer Summe der ersten unteren Hüllfunktion und der ersten oberen Hüllfunktion ist, zu jedem Zeitpunkt (t) des Zeitabschnitts (t0, t1),

- Bestimmung einer ersten Normierungsfunktion, die gleich einer Hälfte einer Differenz zwischen der ersten unteren Hüllfunktion und der ersten oberen Hüllfunktion ist, zu jedem Zeitpunkt (t) des Zeitabschnitts (t0, t1),

- Anwendung der ersten Verlagerungsfunktion und der ersten Normierungsfunktion auf das erste differentielle Signal polarimetrischer Interferometrie, um eine erste Funktion örtlich normierter differentieller polarimetrischer Interferometrie zu jedem Zeitpunkt (t) des Zeitabschnitts (t0, t1) zu bilden, und

- Ableitung eines Maßes optischer Phasenverschiebung in Abhängigkeit von der Zeit über den besagten Zeitabschnitt (t0, t1) aus der ersten Funktion örtlich normierter differentieller polarimetrischer Interferometrie,

- Berechnung der Ätztiefe in Abhängigkeit von der Zeit aus dem Maß optischer Phasenverschiebung.

**2.** Verfahren gemäß Anspruch 1, bei dem der Schritt des Aufteilens durch Polarisation des interferometrischen Strahls außerdem eine dritte Polarisationskomponente (36) und eine vierte Polarisationskomponente (38) erzeugt, wobei die dritte und die vierte Polarisationskomponente zueinander senkrecht stehen und die erste, die zweite, die dritte und die vierte Polarisationskomponente voneinander unabhängig sind und wobei das Verfahren außerdem die folgenden Schritte aufweist:

- Erfassen, in Abhängigkeit von der Zeit (t), über den Zeitabschnitt (t0, t1), eines dritten Signals interferometrischer Stärke bezüglich der dritten Polarisationskomponente und eines vierten Signals interferometrischer Stärke bezüglich der vierten Polarisationskomponente,

- Berechnung eines zweiten differentiellen Signals polarimetrischer Interferometrie in Abhängigkeit von linearen Kombinationen des dritten Signals interferometrischer Stärke und des vierten Signals interferometrischer Stärke,

- Berechnung einer zweiten unteren Hüllfunktion und einer zweiten oberen Hüllfunktion des zweiten differentiellen Signals polarimetrischer Interferometrie,

- Bestimmung einer zweiten Verlagerungsfunktion, die gleich einer Hälfte einer Summe der zweiten unteren Hüllfunktion und der zweiten oberen Hüllfunktion ist, zum Zeitpunkt t,

- Bestimmung einer zweiten Normierungsfunktion, die gleich einer Hälfte einer Differenz zwischen der zweiten unteren Hüllfunktion und der zweiten oberen Hüllfunktion ist, zum Zeitpunkt t,

- Anwendung der zweiten Verlagerungsfunktion und der zweiten Normierungsfunktion auf das zweite differentielle Signal polarimetrischer Interferometrie, um eine zweite Funktion örtlich normierter differentieller polarimetrischer Interferometrie zu bilden, und bei dem

- die Ableitung des Maßes optischer Phasenverschiebung in Abhängigkeit von der Zeit über den besagten Zeitabschnitt (t0, t1) von einem Verhältnis zwischen der ersten Funktion örtlich normierter differentieller polarimetrischer Interferometrie und der zweiten Funktion örtlich normierter differentieller polarimetrischer Interferometrie ausgehend ausgeführt wird.

3. Verfahren gemäß Anspruch 2, bei dem die dritte Polarisationskomponente und die vierte Polarisationskomponente unter den linearen beziehungsweise kreisförmigen Polarisationskomponenten ausgewählt werden.

4. Verfahren gemäß einem der Ansprüche 2 bis 3, bei dem das zweite differentielle Signal polarimetrischer Interferometrie gleich einer Differenz zwischen dem dritten Signal interferometrischer Stärke und dem vierten Signal interferometrischer Stärke, dividiert durch eine Summe des dritten Signals interferometrischer Stärke und des vierten Signals interferometrischer Stärke, ist.

5. Verfahren gemäß einem der Ansprüche 1 bis 4, bei dem die erste Polarisationskomponente und die zweite Polarisationskomponente unter den linearen beziehungsweise kreisförmigen Polarisationskomponenten ausgewählt werden.

6. Verfahren gemäß einem der Ansprüche 1 bis 5, bei dem das erste differentielle Signal polarimetrischer Interferometrie gleich einer Differenz zwischen dem ersten Signal interferometrischer Stärke und dem zweiten Signal interferometrischer Stärke, dividiert durch eine Summe des ersten Signals interferometrischer Stärke und des zweiten Signals interferometrischer Stärke, ist.

7. Verfahren gemäß einem der Ansprüche 1 bis 6, bei dem der Schritt des Berechnens einer ersten und/oder einer zweiten unteren Hüllfunktion einen Schritt des linearen oder polynomialen Interpolierens aufweist und/oder bei dem der Schritt des Berechnens einer ersten und/oder einer zweiten oberen Hüllfunktion einen weiteren Schritt des linearen oder polynomialen Interpolierens aufweist.

8. Verfahren gemäß einem der Ansprüche 1 bis 7, das außerdem vor dem Schritt des Berechnens der Hüllfunktion einen Schritt des Filtems des ersten Signals interferometrischer Stärke beziehungsweise/oder des zweiten Signals interferometrischer Stärke aufweist.

9. Differentielles polarimetrisches Interferometer mit

- einer Lichtquelle (1), die dazu ausgelegt ist, einen Lichtstrahl (2) zu erzeugen,

- einem optischen Strahlteiler (3), der dazu ausgelegt ist, den Lichtstrahl (2) in einen ersten einfallenden Strahl (21) und einen zweiten einfallenden Strahl (22) aufzuteilen, wobei der erste einfallende Strahl (21) auf eine erste Zone (11) einer einem Ätzverfahren unterzogenen Probe (10) gerichtet wird, um einen ersten reflektierten Strahl (31) zu erzeugen, und entsprechend der zweite einfallende Strahl (22) auf eine zweite Zone (12) der Probe gerichtet wird, um einen zweiten reflektierten Strahl (32) zu erzeugen,

- einem Strahlkombinierer, der dazu ausgelegt ist, den ersten reflektierten Strahl (31) und den zweiten reflektierten Strahl (32) zu rekombinieren, um einen interferometrischen Strahl zu bilden,

- einem Polarisationsteiler (52), der dazu ausgelegt ist, den interferometrischen Strahl in wenigstens eine erste Polarisationskomponente (35) und eine zweite Polarisationskomponente (37) aufzuteilen, wobei die erste Polarisationskomponente und eine zweite Polarisationskomponente zueinander senkrecht stehen,

- einem ersten Detektor (81), der dazu ausgelegt ist, die erste Polarisationskomponente (35) zu erfassen und in Abhängigkeit von der Zeit (t), über einen Zeitabschnitt (t0, t1), ein erstes Signal interferometrischer Stärke zu erzeugen, und einem zweiten Detektor (82), der dazu ausgelegt ist, die zweite Polarisationskomponente (37) zu erfassen und in Abhängigkeit von der Zeit (t), über einen Zeitabschnitt (t0, t1), ein zweites Signal interferometrischer Stärke zu erzeugen,

**dadurch gekennzeichnet, daß** das differentielle polarimetrische Interferometer einen Rechner (91, 92, 95) aufweist, der dazu ausgelegt ist,

- ein erstes differentielles Signal polarimetrischer Interferometrie in Abhängigkeit von linearen Kombinationen des ersten Signals interferometrischer Stärke und des zweiten Signals interferometrischer Stärke zu berechnen,
- eine erste untere Hüllfunktion und eine erste obere Hüllfunktion des ersten differentiellen Signals polarimetrischer Interferometrie im Zeitabschnitt (t0, t1) zu berechnen,
- eine erste Verlagerungsfunktion, die gleich einer Hälfte einer Summe der ersten unteren Hüllfunktion und der ersten oberen Hüllfunktion ist, zu jedem Zeitpunkt t zu bestimmen,
- eine erste Normierungsfunktion, die gleich einer Hälfte einer Differenz zwischen der ersten unteren Hüllfunktion und der ersten oberen Hüllfunktion ist, zu jedem Zeitpunkt t des Zeitabschnitts (t0, t1) zu bestimmen,
- die erste Verlagerungsfunktion und die erste Normierungsfunktion auf das erste differentielle Signal polarimetrischer Interferometrie anzuwenden, um eine erste Funktion örtlich normierter differentieller polarimetrischer Interferometrie zu bilden, und
- ein Maß optischer Phasenverschiebung in Abhängigkeit von der Zeit über den besagten Zeitabschnitt (t0, t1) aus der ersten Funktion örtlich normierter differentieller polarimetrischer Interferometrie abzuleiten,
- die Ätztiefe in Abhängigkeit von der optischen Phasenverschiebung zu berechnen.

10. Differentielles polarimetrisches Interferometer gemäß Anspruch 9, das außerdem

- einen weiteren Polarisationsteiler (53), der dazu ausgelegt ist, den interferometrischen Strahl in eine dritte Polarisationskomponente (36) und eine vierte Polarisationskomponente (38) aufzuteilen, wobei die dritte Polarisationskomponente (36) und die vierte Polarisationskomponente (38) zueinander senkrecht stehen und von der ersten Polarisationskomponente (35) und der zweiten Polarisationskomponente (37) unabhängig sind,
- einen dritten Detektor (83), der dazu ausgelegt ist, die dritte Polarisationskomponente (36) zu erfassen und ein drittes Signal interferometrischer Stärke in Abhängigkeit von der Zeit (t) über den Zeitabschnitt (t0, t1) zu erzeugen, und einen vierten Detektor (84), der dazu ausgelegt ist, die vierte Polarisationskomponente (38) zu erfassen und ein viertes Signal interferometrischer Stärke in Abhängigkeit von der Zeit (t) über den Zeitabschnitt (t0, t1) zu erzeugen, aufweist

und bei dem der Rechner dazu ausgelegt ist,

- ein zweites differentielles Signal polarimetrischer Interferometrie in Abhängigkeit von linearen Kombinationen des dritten Signals interferometrischer Stärke und des vierten Signals interferometrischer Stärke zu berechnen,
- eine zweite untere Hüllfunktion und eine zweite obere Hüllfunktion des zweiten differentiellen Signals polarimetrischer Interferometrie zu berechnen,
- eine zweite Verlagerungsfunktion, die zu jedem Zeitpunkt t gleich einer Hälfte einer Summe der zweiten unteren Hüllfunktion und der zweiten oberen Hüllfunktion ist, zu bestimmen,
- eine zweite Normierangsfunktion, die zu jedem Zeitpunkt t gleich einer Hälfte einer Differenz zwischen der zweiten unteren Hüllfunktion und der zweiten oberen Hüllfunktion ist, zu bestimmen,
- die zweite Verlagerungsfunktion und die zweite Normierungsfunktion auf das zweite differentielle Signal polarimetrischer Interferometrie anzuwenden, um eine zweite Funktion örtlich normierter differentieller polarimetrischer Interferometrie zu bilden, und
- das Maß optischer Phasenverschiebung in Abhängigkeit von der Zeit über den besagten Zeitabschnitt (t0, t1) von einem Verhältnis zwischen der ersten Funktion örtlich normierter differentieller polarimetrischer Interferometrie und der zweiten Funktion örtlich normierter differentieller polarimetrischer Interferometrie ausgehend abzuleiten.

11. Glimmentladungsspektrometrievorrichtung mit einem differentiellen polarimetrischen Interferometer gemäß einem der Ansprüche 9 bis 10.

12. Vorrichtung zur Messung der Ätztiefe, die ein differentielles polarimetrisches Interferometer gemäß einem der Ansprüche 9 bis 10 aufweist, kombiniert mit einer Bildkamera, die dazu ausgelegt ist, ein Bild der ersten Zone und ein Bild der zweiten Zone der Probe zu bilden.

**Claims**

1. A method for measuring etch depth as a function of time by differential polarimetric interferometry, comprising the following steps:

- splitting a light beam (2) into a first incident beam (21) and a second incident beam (22), the first incident beam (21) being directed towards a first area (11) of a sample (10) exposed to an etching treatment to form a first reflected beam (31) and, respectively, the second incident beam (22) being directed towards a second area (12) of the sample to form a second reflected beam (32),

- recombining the first reflected beam (31) and the second reflected beam (32) to form an interferometric beam,

- polarisation splitting the interferometric beam into at least a first polarisation component (35) and a second polarisation component (37), orthogonal to each other;

- detecting, as a function of time (t), over a time interval (t0, t1), a first interferometric intensity signal relating to the first polarisation component (35) and a second interferometric intensity signal relating to the second polarisation component (37);

- calculating a first differential polarimetric interferometry signal as a function of linear combinations of the first interferometric intensity signal and of the second interferometric intensity signal;

- calculating a first lower envelope function and a first upper envelope function of the first differential polarimetric interferometric signal over the time interval (t0, t1);

- determining a first offset function equal to half a sum of the first lower envelope function and the first upper envelope function at each time instant (t) of the time interval (t0, t1);

- determining a first normalisation function equal to half a difference between the first lower envelope function and the first upper envelope function at each time instant (t) of the time interval (t0, t1);

- applying the first offset function and the first normalisation function to the first differential polarimetric interferometry signal to form a first locally-normalised differential polarimetric interferometry function at each time instant (t) of the time interval (t0, t1); and

- extracting an optical phase-shift measurement as a function of time over said time interval (t0, t1), from the first locally-normalised differential polarimetric interferometry function;

- calculating the etch depth as a function of time from the optical phase-shift measurement.

2. The method according to claim 1, wherein the step of polarisation splitting the interferometric beam further generates a third polarisation component (36) and a fourth polarisation component (38), said third and fourth polarisation components being orthogonal to each other, and the first, second, third and fourth polarisation components being independent of each other, and the method further comprising the following steps:

- detecting, as a function of time (t), on the time interval (t0, t1), a third interferometric intensity signal relating to the third polarisation component and a fourth interferometric intensity signal relating to the fourth polarisation component;

- calculating a second differential polarimetric interferometry signal as a function of linear combinations of the third interferometric intensity signal and of the fourth interferometric intensity signal;

- calculating a second lower envelope function and a second upper envelope function of the second differential polarimetric interferometry signal;

- determining a second offset function equal to half a sum of the second lower envelope function and the second upper envelope function at time instant t;

- determining a second normalisation function equal to half a difference between the second lower envelope function and the second upper envelope function at time instant t;

- applying the second offset function and the second normalisation function to the second differential polarimetric interferometry signal to form a second locally-normalised differential polarimetric interferometry function, and wherein

- the extraction of the optical phase-shift measurement as a function of time over said time interval (t0, t1) is performed from a ratio between the first locally-normalised differential polarimetric interferometry function and the second locally-normalised differential polarimetric interferometry function.

3. The method according to claim 2, wherein the third polarisation component and the fourth polarisation component are chosen among linear, or respectively circular, polarisation components.

4. The method according to claims 2 to 3, wherein the second differential polarimetric interferometry signal is equal to a difference between the third interferometric intensity signal and the fourth interferometric intensity signal divided by a sum of the third interferometric intensity signal and the fourth interferometric intensity signal.

5. The method according to one of claims 1 to 4, wherein the first polarisation component and the second polarisation component are chosen among linear, or respectively circular, polarisation components.

6. The method according to one of claims 1 to 5, wherein the first differential polarimetric interferometry signal is equal to a difference between the first interferometric intensity signal and the second interferometric intensity signal divided by a sum of the first interferometric intensity signal and the second interferometric intensity signal.

7. The method according to one of claims 1 to 6, wherein the step of calculating a first, and/or respectively second, lower envelope function includes a step of linear or polynomial interpolation and/or the step of calculating a first, and/or respectively second, upper envelope function includes another step of linear or polynomial interpolation.

8. The method according to one of claims 1 to 7, further comprising a step of filtering the first interferometric intensity signal and/or, respectively, the second interferometric intensity signal, before the step of envelope function calculation.

9. A differential polarimetric interferometer comprising:

- a light source (1) adapted to generate a light beam (2);
- an optical beam splitter (3) adapted to split the light beam (2) into a first incident beam (21) and a second incident beam (22), the first incident beam (21) being directed towards a first area (11) of a sample exposed to an etching treatment to form a first reflected beam (31) and, respectively, the second incident beam (22) being directed towards a second area (12) of the sample to form a second reflected beam (32);
- a beam combiner (3) adapted to recombine the first reflected beam (31) and the second reflected beam (32) to form an interferometric beam;
- a polarisation splitter (52) adapted to split the interferometric beam into at least a first polarisation component (35) and a second polarisation component (37), the first polarisation component and the second polarisation component being orthogonal to each other;
- a first detector (81) adapted to receive the first polarisation component (35) and to generate a first interferometric intensity signal as a function of time (t) over a time interval (t0, t1) and a second detector (82) adapted to receive the second polarisation component (37) and to generate a second interferometric intensity signal as a function of time (t) over a time interval (t0, t1);

**characterized in that** the differential polarimetric interferometer includes a calculator (91, 92, 95) adapted to:

- calculate a first differential polarimetric interferometry signal as a function of linear combinations of the first interferometric intensity signal and of the second interferometric intensity signal,
- calculate a first lower envelope function and a first upper envelope function of the first differential polarimetric interferometry signal over the time interval (t0, t1),
- determine a first offset function equal, at each time instant t, to half a sum of the first lower envelope function and the first upper envelope function,
- determine a first normalisation function equal, at each time instant t of the time interval (t0, t1), to half a difference between the first lower envelope function and the first upper envelope function,
- apply the first offset function and the first normalisation function to the first differential polarimetric interferometry signal to form a first locally-normalised differential polarimetric interferometry function, and
- extract an optical phase-shift measurement as a function of time over said time interval (t0, t1), from the first locally-normalised differential polarimetric interferometry function, and
- calculate the etch depth as a function of the optical phase-shift.

10. The differential polarimetric interferometer according to claim 9, further comprising:

- another polarisation splitter (53) adapted to split the interferometric beam into a third polarisation component (36) and a fourth polarisation component (38), the third polarisation component (36) and the fourth polarisation component (38) being orthogonal to each other and being independent of the first polarisation component (35) and of the second polarisation component (37);
- a third detector (83) adapted to receive the third polarisation component (36) and to generate a third interferometric intensity signal as a function of time (t) over the time interval (t0, t1) and a fourth detector (84) adapted to receive the fourth polarisation component (38) and to generate a fourth interferometric intensity signal as a function of time (t) over the time interval (t0, t1);

and wherein the calculator is adapted to:

- calculate a second differential polarimetric interferometry signal as a function of linear combinations of the third interferometric intensity signal and of the fourth interferometric intensity signal;
- calculate a second lower envelope function and a second upper envelope function of the second differential polarimetric interferometry signal over the time interval (t0, t1);
- determine a second offset function equal, at each time instant t, to half a sum of the second lower envelope function and the second upper envelope function;

- determine a second normalisation function equal, at each time instant t of the time interval (t0, t1), to half a difference between the second lower envelope function and the second upper envelope function;

- apply the second offset function and the second normalisation function to the second differential polarimetric interferometry signal to form a second locally-normalised differential polarimetric interferometry function; and

- perform the extraction of the optical phase-shift measurement as a function of time over said time interval (t0, t1), from a ratio between the first locally-normalised differential polarimetric interferometry function and the second locally-normalised differential polarimetric interferometry function.

11. A glow discharge spectrometry apparatus comprising a differential polarimetric interferometer according to one of claims 9 to 10.

12. An etching control device comprising a differential polarimetric interferometer according to one of claims 9 to 10, combined with a visualisation camera adapted to form an image of the first area and of the second area of the sample.

# Fig.1

# Fig.2

# Fig.3

Fig.4

Fig.5

Fig.6

**Fig.7**

**Fig.8**

**Fig.9**

# Fig.10

# Fig.11

# Fig.12

**EP 3 555 558 B1**

## RÉFÉRENCES CITÉES DANS LA DESCRIPTION

**Documents brevets cités dans la description**

- FR 2760085 A1

- WO 2015166186 A1